**Europäisches Patentamt**

**European Patent Office**

**Office européen des brevets**

(11) Numéro de publication: **0 168 456**
**B1**

(12) **FASCICULE DE BREVET EUROPÉEN**

(45) Date de publication du fascicule du brevet:
06.06.88

(21) Numéro de dépôt: **85900680.1**

(22) Date de dépôt: **15.01.85**

(86) Numéro de dépôt international:
**PCT/FR 85/00007**

(87) Numéro de publication internationale:
**WO 85/03385 (01.08.85 Gazette 85/17)**

(51) Int. Cl.⁴: **H 01 L 25/12**, H 01 L 23/40

(54) **DISPOSITIF DE MONTAGE ET DE CONNEXION POUR SEMI-CONDUCTEURS DE PUISSANCE.**

(30) Priorité: **23.01.84 FR 8400983**
**23.01.84 FR 8400984**

(43) Date de publication de la demande:
**22.01.86 Bulletin 86/4**

(45) Mention de la délivrance du brevet:
**06.06.88 Bulletin 88/23**

(84) Etats contractants désignés:
**BE CH DE GB LI NL SE**

(56) Documents cité:
**WO-A-79/00578**
**WO-A-83/02527**
**FR-A-2 384 354**
**US-A-4 224 663**

**Electronics Weekly, no. 706, 27 mars 1974, (Londres, GB), B. Roehr "SC reliability depends on proper mounting procedure", page 27**

(73) Titulaire: **LA TELEMECANIQUE ELECTRIQUE, 33 bis, avenue du Maréchal Joffre, F-92000 Nanterre (FR)**

(72) Inventeur: **LECOMTE, René, 16, rue des Lauriers, F-95540 Mery sur Oise (FR)**

(74) Mandataire: **Marquer, Francis, 35, Avenue Victor Hugo Résidence Chamfleury, F-78180 Voisins- le- Bretonneux (FR)**

## Description

La présente invention concerne un dispositif de montage et de connexion pour au moins un composant semi-conducteur de puissance sur un dissipateur thermique unilatéral. Un tel dispositif comprend le dissipateur et un dispositif de serrage associé à chaque composant semi-conducteur pour appliquer celui-ci sur le dissipateur, et prenant appui, d'une part, sur le dissipateur et, d'autre part, sur le composant semi-conducteur par l'intermédiaire d'une barre de connexion.

Les dispositifs de montage connus pour semi-conducteurs de puissance à refroidissement unilatéral, c'est-à-dire s'effectuant sur une seule face du semi-conducteur, utilisent parfois un boîtier isolant de hauteur calibrée en fonction de celle du semi-conducteur; dans le boîtier se trouve un ressort taré de manière à produire l'effort de serrage prescrit. La connexion électrique de puissance est réalisée soit par une tige filetée sortant du boîtier à la partie supérieure de celui-ci, soit par une plage de raccordement rigide sortant du boîtier sur l'un des côtés de celui-ci.

Un tel dispositif a pour inconvénient de nécessiter une association contraignante du composant semi-conducteur, de son boîtier et du ressort de serrage, en particulier en fonction de la hauteur et du diamètre du composant; de plus, le mode de connexion utilisé entraîne une cascade de contacts électriques provoquant des échauffements successifs nocifs pour le semi-conducteur, et/ou des contraintes mécaniques dues à des connexions rigides et dommageables pour la fiabilité du semi-conducteur.

Dans un autre dispositif de montage connu, du type à refroidissement bilatéral, c'est-à-dire par les deux faces du composant semi-conducteur, on utilise des brides de serrage destinées à enserrer deux dissipateurs thermiques enfermant le semi-conducteur. La bride comporte un ressort taré afin d'obtenir l'effort de serrage prescrit. Dans ce cas, les connexions électriques sont réalisées sur les dissipateurs qui assurent également la fonction de conducteurs électriques.

Un tel dispositif, transposé à des montages à refroidissement unilatéral faisant intervenir un ou plusieurs composants semi-conducteurs, a pour inconvénient de requérir une adaptation lorsqu'on désire utiliser des semi-conducteurs de hauteurs différentes ou à larges tolérances de hauteur, soit lors du montage d'origine, soit lors du remplacement d'un semi-conducteur sur le lieu d'exploitation. On obtient l'adaptation souhaitée au moyen d'une connexion à tresse ou au moyen d'une connexion rigide avec insertion de cales ou d'autres systèmes de rattrapage de cotes. Ces solutions ont dans l'ensemble pour inconvénient d'être relativement onéreuses.

La présente invention a notamment pour but de remédier aux défauts précités et de créer un dispositif simple adapté à des composants semi-conducteurs de puissance de hauteurs variables et facilitant le montage et la connexion desdits composants.

Elle a pour autre but d'éviter la transmission à de tels composants semi-conducteurs des efforts susceptibles d'être exercés sur les éléments de connexion du dispositif.

Selon l'invention, dans un dispositif de montage et de connexion du type précité, la barre de connexion insérée entre le composant semi-conducteur et le dispositif de serrage de celui-ci est feuilletée, de manière à présenter sur sa longueur, une grande flexibilité à partir d'une plage de fixation formée sur un support fixe.

Il en résulte que le dispositif de connexion s'adapte de lui-même, sans aucun réglage ni adjonction de cale, à des semi-conducteurs de hauteurs variables en fonction de leur origine ou de leurs tolérances de fabrication.

La barre feuilletée peut avantageusement être immobilisée par des moyens de fixation sur la plage de fixation du support constitué par un cadre isolant, lui-même fixé au dissipateur thermique, afin de pouvoir fléchir à partir de cette plage de fixation jusqu'à sa plage de serrage sur le(s) semi-conducteur(s). Il en résulte la possibilité d'un démontage aisé de la barre et une grande facilité de remplacement des semi-conducteurs.

Lorsque le dispositif comporte plusieurs composants semi-conducteurs, le cadre isolant peut présenter entre deux semi-conducteurs voisins un point d'appui pour la barre feuilletée, la hauteur de ce point d'appui par rapport à la surface du dissipateur sur laquelle reposent les semi-conducteurs étant inférieure à la hauteur minimale admissible des semi-conducteurs.

De plus, le dispositif peut avantageusement présenter pour la barre feuilletée de connexion des moyens de retenue tels que des pions, logements ou nervures évitant la transmission aux semi-conducteurs des efforts exercés le cas échéant sur les éléments de connexion associés à la barre feuilletée.

Un premier élément de connexion rigide peut avantageusement être disposé en contact électrique direct avec la barre feuilletée, tout en étant logé et calé dans le cadre isolant et fixé à celui-ci de manière à soulager la barre feuilletée des efforts imposés audit élément de connexion.

Un deuxième élément de connexion rigide constitué par une lame peut être mis en position et calé dans le cadre isolant au moyen d'une conformation de retenue prévue par exemple dans le cadre, en étant inséré entre le dissipateur et le cadre isolant, l'extrémité du deuxième élément de connexion étant en contact électrique direct avec le dissipateur.

Les avantages ainsi que les particularités de l'invention apparaîtront clairement à la lumière de la description ci-après.

La figure 1 représente en perspective un dispositif de montage et de connexion conforme à l'invention, comportant deux semi-conducteurs de puissance et une barre de connexion associée à ces semi-conducteurs;

La figure 2 représente en élévation latérale une coupe du dispositif de la figure 1 selon un plan de symétrie de la barre;

La figure 3 est une vue similaire montrant le profil pris par la barre avec deux semi-conducteurs de hauteurs différentes;

La figure 4 montre en élévation de face le dispositif de la figure 1;

La figure 5 montre à plus grande échelle le détail A de la figure 2;

La figure 6 représente en coupe selon le plan V-V repéré sur la figure 4 l'insertion d'un élément de connexion entre le dissipateur et le cadre.

Le dispositif de montage et de connexion représenté sur les figures présente un cadre moulé 10 en matériau isolant muni d'un logement 11 pour recevoir par emboîtement un dissipateur thermique unilatéral 12 par exemple en aluminium; le cadre 10 est fixé au dissipateur au moyen de vis et comporte deux fenêtres 13, 14 prévues pour loger chacune un composant semi-conducteur de puissance 15, 16 de hauteur et de diamètre variables, par exemple une diode ou un thyristor. Il va de soi que le cadre peut présenter un plus grand nombre de fenêtres de logement de semi-conducteurs. Plusieurs tels cadres peuvent être associés par exemple par emboîtement et fixation mutuelle.

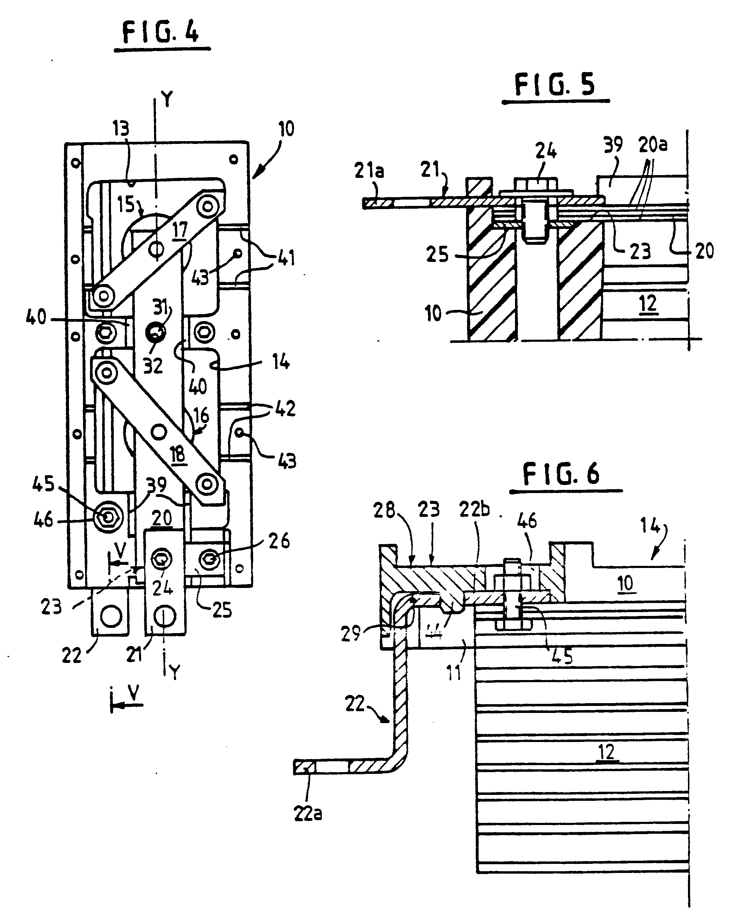

A chaque semi-conducteur 15, 16 est associé un dispositif de serrage 17, 18 visible sur la figure 4 et prenant appui, d'une part, sur le dissipateur et, d'autre part, sur le semi-conducteur par l'intermédiaire d'une barre commune 20 de connexion en cuivre. Chaque dispositif de serrage 17, 18 exerce sur son semi-conducteur 15, 16 un effort respectif $F_1$, $F_2$ et comprend une bride disposée à 45° par rapport à l'axe longitudinal Y-Y de la barre 20, les extrémités de la bride étant conformées avec un biseau, un pan coupé ou un arrondi pour respecter une distance d'isolement prédéterminée par rapport à une paroi métallique adjacente d'un châssis ou à une bride adjacente.

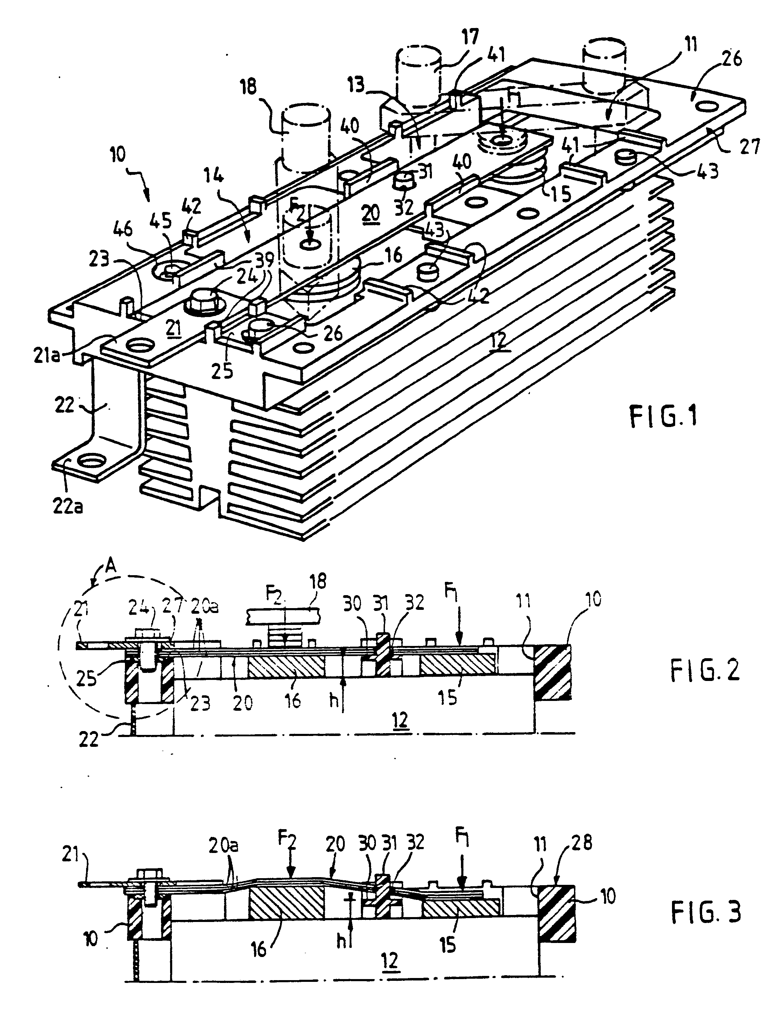

Selon l'invention, la barre 20 est feuilletée et se compose de plusieurs lames 20a superposées (figure 2) dont l'aptitude à la flexion est prédéterminée en corrélation avec les efforts $F_1$, $F_2$; on utilise dans le présent exemple trois lames. La barre 20 est en contact électrique avec un premier élément 21 de connexion tel qu'une lame, tandis qu'un deuxième élément de connexion 22 est logé dans le cadre et fixé directement au dissipateur 12 en contact électrique direct avec celui-ci pour assurer un trajet de courant 21, 20, 15, 16, 12, 22; les éléments de connexion assurent, grâce à leurs extrémités libres 21a, 22a, le raccordement de conducteurs extérieurs au dispositif de montage.

La barre feuilletée 20 repose par une extrémité sur une plage d'appui 23 du cadre 10 (figure 5) et elle est fixée sur cette plage par des moyens de fixation comprenant une vis 24; la vis 24 sert également à maintenir l'élément de connexion 21 et coopère à cet effet avec un taraudage d'une barrette transversale fixe en acier 25 calée dans un logement prévu sur le cadre et fixée elle-même par une vis 26 au cadre; la vis 24 traverse librement une ouverture 27 ménagée dans la barre feuilletée, ceci permettant de soulager la barre 20 des efforts de pivotement ou d'arrachement exercés sur la lame 21. La barre 20 et la lame 21 sont rapportées sur une face frontale 28 du cadre, tandis que la lame 22 est rapportée sous une face arrière 29 du cadre.

Entre les deux fenêtres 13, 14, le cadre 10 comprend une plage d'appui 30 munie d'un téton 31 pénétrant dans un orifice 32 de la barre feuilletée 20. La hauteur h̲ de la plage 30 par rapport à la surface supérieure du dissipateur 12 est, de préférence, inférieure à la hauteur minimale admissible des semi-conducteurs 15, 16. La barre 20 est, par ailleurs, immobilisée par des moyens de retenue tels que des butées latérales 39, 40 venues de moulage avec le cadre 10; ces butées empêchent le déplacement de la barre transversalement à son axe Y-Y.

On a souligné sur la figure 3, de manière fortement exagérée, l'aptitude à la flexion de la barre feuilletée 20 dans le cas où cette barre est appliquée sur deux semi-conducteurs 15, 16 de hauteurs différentes. La différence de hauteur que la barre 20 est capable d'absorber peut par exemple être de l'ordre de 2,5 mm.

La barre feuilletée 20 peut avantageusement être mise en place et fixée sur le cadre 10 perpendiculairement à la position illustrée sur la figure 1, et ce au moyen de logements ou de nervures 41, 42 et de pions 43 venus de moulage avec le cadre; l'orifice 32 prévu dans la barre feuilletée laisse alors le passage au pion 43 de positionnement et d'appui.

Sur la coupe illustrée figure 6, on voit que le deuxième élément de connexion 22 est constitué par une lame pliée de manière à présenter une première extrémité 22a de connexion avec un conducteur externe et une deuxième extrémité 22b insérée entre le dissipateur 12 et le cadre 10. L'extrémité 22a est ainsi séparée d'une distance suffisante de l'extrémité de raccordement 21a de la lame 21. L'extrémité 22b est positionnée par rapport au cadre grâce à un pion 44 prévu sur celui-ci et saillant dans le logement 11 du dissipateur. La lame 22 est fixée au dissipateur 12 au moyen d'un couple vis-écrou 45 dont l'écrou est accessible via un orifice 46 du cadre.

Il va de soi que l'on peut apporter au mode de réalisation décrit des modifications sans pour autant sortir du cadre de l'invention.

## Revendications

1. Dispositif de montage et de connexion pour au moins un semi-conducteur de puissance (15, 16) sur un dissipateur thermique unilatéral (12) comprenant un tel dissipateur et un dispositif de serrage (17, 18) associé à chaque composant semi-conducteur (15, 16) pour appliquer celui-ci sur le dissipateur, le dispositif de serrage prenant appui, d'une part, sur le dissipateur et, d'autre part, sur le semi-conducteur par l'intermédiaire d'une barre de connexion (20), caractérisé en ce que la barre de connexion (20) est feuilletée pour présenter sur sa longueur et à partir d'une plage de fixation (23) formée sur un support fixe (10), une flexibilité permettant à la barre de s'appliquer sur des plages d'appui de composants semi-conducteurs (15, 16) de hauteurs différentes.

2. Dispositif selon la revendication 1, caractérisé en ce que la barre feuilletée (20) comprend plusieurs lames superposées (20a), la somme des hauteurs de ces lames étant prédéterminée en fonction de l'intensité du courant susceptible de parcourir la barre et l'épaisseur de chaque lame étant prédéterminée en fonction de la souplesse que l'on désire donner à la barre feuilletée.

3. Dispositif selon l'une des revendications 1 et 2, comprenant au moins deux semi-conducteurs, caractérisé en ce qu'il est prévu entre deux semi-conducteurs voisins (15, 16) un point d'appui (30) pour la barre feuilletée (20), la hauteur (h) de ce point d'appui par rapport à la surface du dissipateur (12) étant égale ou inférieure à la hauteur minimale admissible des semi-conducteurs.

4. Dispositif selon l'une des revendications 1 à 3, dans lequel le support fixe est un cadre isolant (10) auquel est fixé le dissipateur (12) et qui présente au moins une fenêtre traversante (13, 14) pour loger le semi-conducteur (15, 16), caractérisé en ce que le cadre (10) porte un premier élément de connexion rigide (21) en contact électrique direct avec la barre feuilletée (20) au voisinage de la plage de serrage (23) de celle-ci, le premier élément de connexion étant calé et fixé dans le cadre à l'aide de moyens de retenue (24, 25) évitant la transmission aux semi-conducteurs (15, 16) des efforts exerces sur ledit élément.

5. Dispositif selon l'une des revendications 1 à 4, caractérisé en ce qu'il comporte un deuxième élément de connexion rigide (22) en contact électrique direct avec le dissipateur (12), le deuxième élément de connexion étant calé dans le cadre (10) et présentant une extrémité (22b) serrée entre le cadre et le dissipateur.

6. Dispositif selon l'une des revendications 1 à 5, caractérisé en ce que le cadre isolant (10) présente des conformations de retenue (28, 30, 39-42) permettant de positionner la barre feuilletée (20) et de soulager celle-ci des efforts exercés sur les éléments de connexion.

7. Dispositif selon la revendication 6, caractérisé en ce que les conformations de retenue (28, 30, 39-42) prévues sur le cadre isolant (10) sont agencées pour autoriser le montage de la barre feuilletée (20) selon deux directions perpendiculaires entre elles.

8. Dispositif selon la revendication 7, caractérisé en ce que chaque dispositif de serrage présente une bride (17, 18) disposée à 45° par rapport à l'axe longitudinal de la barre feuilletée, les extrémités de la bride étant conformées pour respecter une distance d'isolement prédéterminée par rapport à une paroi métallique voisine ou à une bride adjacente.

**Claims**

1. A device for mounting and connecting at least one power semi-conductor (15, 16) to a unilateral heat sink (12) comprising such a heat sink and a clamping device (17, 18) associated with each semi-conductor component (15, 16) for applying it against the heat sink, the clamping device bearing, on the one hand, on the heat sink and, on the other hand, on the semi-conductor through a connecting bar (20), characterized in that said connecting bar (20) is laminated so as to have, along its length and from a fixing zone (23) formed on a fixed support (10), an amount of flexibility allowing the bar to be applied against the bearing zones of semi-conductor components (15, 16) of different heights.

2. The device as claimed in claim 1, characterized in that said laminated bar (20) comprises several superimposed blades (20a) the sum of the heights of these blades being predetermined depending on the strength of the current likely to flow through the bar and the thickness of each blade being predetermined as a function of the flexibility it is desired to give to the laminated bar.

3. The device as claimed in one of claims 1 and 2, comprising at least two semi-conductors characterized in that, between two adjacent semi-conductors (15, 16), a bearing point (30) is provided for the laminated bar (20), the height (h) of this bearing point with respect to the surface of the heat sink (12) being equal to or less than the minimum admissible height of the semi-conductors.

4. A device as claimed in one of claims 1 to 3, in which said fixed support is an insulating frame (10) to which the heat sink (12) is fixed and which has at least one through window (13, 14) for housing the semi-conductor (15, 16), characterized in that said frame (10) supports a first rigid connection element (21) in direct electric contact with the laminted bar (20) in the neighborhood of a clamping zone (23) thereof, said first connecting element being clamped and fixed in the frame by means of retaining means (24, 25) avoiding transmission to the semi-conductors (15, 16) of the forces exerted on said element.

5. The device as claimed in one of claims 1 to 4, characterized in that it further comprises a second rigid connection element (22) in direct electric contact with the heat sink (12), said second connecting element being clamped in the frame (10) and having one end (22b) clamped between the frame and the heat sink.

6. The device as claimed in one of claims 1 to 5, characterized in that said insulating frame (10) has retaining structures (28, 30, 39-42) for positioning said laminated bar (20) and relieving it of the forces exerted on said connection elements.

7. The device as claimed in claim 6, characterized in that said retaining structures (28, 30, 39-42) provided on the insulating frame (10) are adapted for allowing the laminated bar (20) to be fitted in two directions perpendicular with respect to each other.

8. The device as claimed in claim 7, characterized in that each clamping device has a flange (17, 18) disposed at 45° with respect to the longitudinal axis of the laminated bar, the ends of the flange being shaped so as to respect a predetermined insulating distance from a neighboring metal wall or an adjacent flange.

**Patentansprüche**

1. Anordnung zum Montieren und Verbinden von mindestens einem Leistungshalbleiter (15, 16) mit einem einseitigen Abstrahlblech (12), welche ein solches Abstrahlblech aufweist und eine Klemmvorrichtung (17, 18), die jeder Halbleiterkomponente (15, 16) zugeordnet ist, um diese gegen das Abstrahlblech anzulegen, wobei die Klemmvorrichtung einerseits auf dem Abstrahlblech und andererseits auf dem Halbleiter mittels einer Verbindungsstange (20) ruht, dadurch gekennzeichnet, dass die Verbindungsstange (20) geblecht ist, um entlang ihrer Längenausdehnung und ab einem, auf einem stationären Träger (10) gebildeten Befestigungspunkt (23) eine Biegsamkeit aufzuweisen, die es ihr ermöglicht, gegen Auflageflächen von Halbleiterkomponenten (15, 16) verschiedener Höhen anzuliegen.

2. Vorrichtung nach Anspruch 1, dadurch gekennzeichnet, dass die geblechte Stange (20) mehrere übereinanderliegende Lamellen (20a) aufweist, wobei die Summe der Höhen dieser Lamellen, im Verhältnis zur Stromstärke bestimmt wird, die durch die Stange fliessen kann und die Dicke jeder Lamelle im Verhältnis zur Biegsamkeit bestimmt wird, welche die geblechte Stange haben soll.

3. Vorrichtung nach einem der Ansprüche 1 und 2, mit wenigstens zwei Halbleitern, dadurch gekennzeichnet, dass zwischen zwei benachbarten Halbleitern (15, 16) ein Auflagepunkt (30) für die geblechte Stange (20) vorgesehen ist, wobei die Höhe (h) dieses Auflagepunktes im Verhältnis zur Oberfläche des Abstrahlbleches (12) gleich der geringsten zulässigen Höhe der Halbleiter oder geringer als diese ist.

4. Vorrichtung nach einem der Ansprüche 1 bis 3, in der der stationäre Träger ein Isolierrahmen (10) ist, auf dem das Abstrahlblech (12) befestigt ist und welcher mindestens ein durchgehendes Fenster (13, 14) zur Aufnahme des Halbleiters (15, 16) aufweist, dadurch gekennzeichnet, dass der Rahmen (10) ein erstes starres Verbindungselement (21) trägt, welches in der Nähe der Klemmfläche (23) der geblechten Stange (20) mit dieser in direktem elektrischen Kontakt steht, wobei das erste Verbindungselement im Rahmen eingeklemmt und befestigt ist, mittels Haltemitteln (24, 25), welche die Übertragung von auf besagtes Element ausgeübten Kräften auf die Halbleiter (15, 16) vermeiden.

5. Vorrichtung nach einem der Ansprüche 1 bis 4, dadurch gekennzeichnet, dass sie ein zweites starres Verbindungselement (22) aufweist, welches mit dem Abstrahlblech (12) in direkter elektrischer Verbindung steht, wobei das zweite Verbindungselement in den Rahmen (10) eingeklemmt ist und eines seiner Enden (22b) zwischen dem Rahmen und dem Abstrahlblech eingezwängt ist.

6. Vorrichtung nach einem der Ansprüche 1 bis 5, dadurch gekennzeichnet, dass der Isolierrahmen (10) Haltestrukturen (28, 30, 39-42) aufweist, die es ermöglichen, die geblechte Stange (20) auszurichten und von der Wirkung der auf das Verbindungselement ausgeübten Kräfte zu entlasten.

7. Vorrichtung nach Anspruch 6, dadurch gekennzeichnet, dass die auf dem Isolierrahmen (10) vorgesehenen Haltestrukturen (28, 30, 39-42) so angeordnet sind, dass sie eine Montage der geblechten Stange (20) in zwei zueinander senkrechten Richtungen ermöglichen.

8. Vorrichtung nach Anspruch 7, dadurch gekennzeichnet, dass jede Klemmvorrichtung einen im Verhältnis zur Längsachse der geblechten Stange in einem Winkel von 45° angeordneten Flansch (17, 18) aufweist, dessen Enden so ausgebildet sind, dass ein bestimmter Isolierabstand zu einer benachbarten Metallwand oder zu einem benachbarten Flansch eingehalten wird.

FIG.1

FIG.2

FIG.3

FIG. 4

FIG. 5

FIG. 6